# EUROPEAN PATENT APPLICATION

(11) **EP 2 543 508 A1**
(43) Date of publication of application: **09.01.2013**
(21) Application number: 11750718.6
(22) Date of filing: 02.03.2011
(51) Int. Cl.: B32B 9/00, B32B 27/30, C23C 14/06, C23C 14/08, C23C 16/34, C23C 16/40, H01L 31/04

(54) **LAYERED PRODUCT AND PROCESS FOR PRODUCING SAME**

(30) Priority: 05.03.2010 JP 2010049508
(71) Applicant: Asahi Glass Company, Limited, Tokyo 100-8405 (JP)
(72) Inventor: SHIDOJI, Eiji, Tokyo 100-8405 (JP); KIHARA, Naoto, Tokyo 100-8405 (JP); NAKAO, Takuya, Tokyo 100-8405 (JP); ARUGA, Hiroshi, Tokyo 100-8405 (JP)
(74) Representative: Müller-Boré & Partner Patentanwälte
(86) International application number: PCT/JP2011/054807
(87) International publication number: WO 2011/108609

(57) **Abstract**

To provide a laminate which is excellent in weather resistance and moisture-proofing property and also excellent in interlayer adhesion and its long-term stability, and a process for its production. A laminate which comprises a substrate sheet containing a fluororesin, an adhesion layer containing an acrylic resin, and a moisture-proofing layer containing, as its main component, at least one inorganic compound selected from the group consisting of inorganic oxides, inorganic nitrides and inorganic oxynitrides, laminated in this order, wherein the surface composition (as measured by X-ray photoelectron spectroscopy) of the surface in contact with the adhesion layer, of the substrate sheet, is such that the atomic percentage of nitrogen is at least 0.2 at% and at most 3.0 at%, and the atomic percentage of oxygen is at least 1.0 at% and at most 5.0 at%.

## Description

### TECHNICAL FIELD

The present invention relates to a laminate useful as a protecting sheet for a solar cell module and a process for its production.

### BACKGROUND ART

In recent years, a clean energy with higher safety is desired with a view to protecting the global environment. Among clean energies expected to be useful in the future, a solar cell is expected to be particularly prospective because of its cleanness, safety and handling efficiency.

The heart of a solar cell to convert sunlight to an electrical energy is cells. As such cells, those made of a semiconductor of monocrystalline, polycrystalline or amorphous silicon type are commonly used. A plurality of such cells are usually arranged in series or in parallel and further protected by various materials in order to maintain their function over a long period of time, to be used as a solar cell module.

A solar cell module usually has a structure such that the side of the cell exposed to sunlight is covered with tempered glass, and the backside is sealed with a back sheet, and a space between the cell and the tempered glass, and a space between the cell and the back sheet, are respectively, filled with a filler made of a thermoplastic resin, (particularly an ethylene/vinyl acetate polymer (hereinafter referred to as EVA)).

Such a solar cell module is required to have a product quality assurance for about 20 to 30 years. The solar cell module is mainly used outdoors, and its constituting materials are required to have weather resistance. The tempered glass and the back sheet play a role to prevent deterioration of the interior of the module due to moisture and thus are also required to have a moisture-proofing property.

The tempered glass is excellent not only in the moisture-proofing property but also in transparency and weather resistance, but poor in flexibility, impact resistance, handling efficiency, etc. Therefore, it has been studied to use a resin sheet, particularly a fluororesin sheet excellent in weather resistance, instead of the tempered glass. However, the resin sheet has a problem such that the moisture-proofing property is low as compared with the tempered glass.

In an attempt to solve the above problem, it has been proposed to form a vapor-deposited thin film of inorganic oxide as a moisture-proofing layer on the resin sheet. For example, Patent Document 1 proposes a protecting sheet wherein a fluororesin sheet is laminated with a resin sheet having a vapor-deposited thin film of inorganic oxide. Further, Patent Document 2 proposes a protecting sheet wherein a vapor-deposited thin film of inorganic oxide is formed on one side of a fluororesin sheet and further in order to improve weather resistance, an anti-fouling layer and/or ultraviolet absorber layer is formed.

However, the above moisture-proofing layer is poor in adhesion to the resin sheet, and when a filler layer is formed in contact with the moisture-proofing layer to constitute a solar cell module, there is a problem that the moisture-proofing layer is likely to peel from the resin sheet. If a space is formed between the resin sheet and the filler layer by such peeling, the durability of the solar cell module tends to deteriorate due to e.g. intrusion of moisture.

In an attempt to solve the above problem, it has been proposed to form a layer (an adhesion layer) to improve the adhesion between the resin sheet and the vapor-deposited thin film of inorganic oxide. For example, Patent Document 3 proposes to form an anchor coating layer containing a complex mixture of an acryl polyol and/or polyester polyol and an isocyanate compound, between a fluororesin substrate layer and a vapor-deposited thin film layer of inorganic oxide. Further, Patent Document 4 proposes to provide, between a substrate and a vapor-deposited layer made of inorganic oxide, a primer layer for vapor deposition made of a resin having an amide ester moiety obtainable by reacting a resin containing an oxazoline group with an acrylic resin made of a poly(meth)acrylic acid and/or a copolymer of a poly(meth)acrylic acid with a comonomer, in a prescribed ratio.

### PRIOR ART DOCUMENTS

### PATENT DOCUMENTS

Patent Document 1: JP-A-2000-138387
Patent Document 2: JP-A-2000-208795
Patent Document 3: JP-A-2009-158778
Patent Document 4: JP-A-2010-16286

### DISCLOSURE OF INVENTION

### TECHNICAL PROBLEM

However, even if the above adhesion layer is provided, a problem still remains such that long-term stability of the adhesion between the fluororesin sheet and the moisture-proofing film is poor.

The present invention has been made in view of such a situation and is to provide a laminate which is excellent in weather resistance and moisture-proofing property and which is also excellent in interlayer adhesion and its long-term stability, and a process for its production.

### SOLUTION TO PROBLEM

In order to solve the above problem, the present invention provides the following.
[1] A laminate which comprises a substrate sheet containing a fluororesin, an adhesion layer containing an acrylic resin, and a moisture-proofing layer containing, as its main component, at least one inorganic compound selected from the group consisting of inorganic oxides, inorganic nitrides and inorganic oxynitrides, laminated in this order, wherein the surface composition (as measured by X-ray photoelectron spectroscopy) of the surface in contact with the adhesion layer, of the substrate sheet, is such that the atomic percentage of nitrogen is at least 0.2 at% and at most 3.0 at%, and the atomic percentage of oxygen is at least 1.0 at% and at most 5.0 at%.
[2] The laminate according to the above [1], wherein the acrylic resin has, in its molecular chain, at least one type of group selected from the group consisting of an ultraviolet-absorbing group, an ultraviolet-stabilizing group, and a group to constitute a polysiloxane structure.
[3] The laminate according to the above [1] or [2], wherein the fluororesin is an ethylene/tetrafluoroethylene copolymer.
[4] The laminate according to any one of the above [1] to [3], wherein the moisture-proofing layer contains, as the inorganic compound, a Si compound or an Al compound.
[5] The laminate according to any one of the above [1] to [4], which has a visible light transmittance of at least 80%.
[6] A protecting sheet for a solar cell module, which uses the laminate as defined in any one of the above [1] to [5].
[7] A process for producing the laminate as defined in any one of the above [1] to [5], which comprises:
   a step of applying surface treatment by glow discharge to at least one surface of the substrate sheet containing a fluororesin, so that in its surface composition (as measured by X-ray photoelectron spectroscopy), the atomic percentage of nitrogen becomes at least 0.2 at% and at most 3.0 at%, and the atomic percentage of oxygen becomes at least 1.0 at% and at most 5.0 at%,
   a step of coating the surface having the above surface composition, of the substrate sheet, with a coating fluid containing the acrylic resin, to form the adhesion layer, and
   a step of forming the moisture-proofing layer on the adhesion layer by a dry system method.
[8] The process for producing the laminate according to the above [7], wherein the atmosphere gas in the glow discharge contains at least one type of gas selected from the group consisting of an inert gas and a nitrogen-containing gas.
[9] The process for producing the laminate according to the above [7], wherein the atmosphere gas in the glow discharge is a mixed gas comprising an inert gas, a carbon oxide-containing gas and a polymerizable unsaturated compound gas.

### ADVANTAGEOUS EFFECTS OF INVENTION

According to the present invention, it is possible to provide a laminate which is excellent in weather resistance and moisture-proofing property and also excellent in interlayer adhesion and its long-term stability, and a process for its production.

### DESCRIPTION OF EMBODIMENTS

The laminate of the present invention is one which comprises a substrate sheet containing a fluororesin, an adhesion layer containing an acrylic resin, and a moisture-proofing layer containing, as its main component, at least one inorganic compound selected from the group consisting of inorganic oxides, inorganic nitrides and inorganic oxynitrides.

Now, the present invention will be described in further detail.

### <Substrate sheet>

The fluororesin to constitute the substrate sheet is not particularly limited so long as it is a thermoplastic resin containing fluorine atoms in the molecular structure of the resin, and various known fluororesins may be used. Specifically, a tetrafluoroethylene resin, a chlorotrifluoroethylene resin, a vinylidene fluoride resin, a vinyl fluoride resin, or a composite of two or more of such resins, may, for example, be mentioned. Among them, a tetrafluoroethylene resin or a chlorotrifluoroethylene resin is preferred, and a tetrafluoroethylene resin is particularly preferred, particularly from the viewpoint of excellent weather resistance, anti-fouling property, etc.

Specifically, the tetrafluoroethylene resin may, for example, be a polytetrafluoroethylene (PTFE), a tetrafluoroethylene/perfluoro(alkoxyethylene) copolymer (PFA), a tetrafluoroethylene/hexafluoropropylene/perfluoro(alkoxyethylene) copolymer (EPE), a tetrafluoroethylene/hexafluoropropylene copolymer (FEP), a tetrafluoroethylene/ethylene copolymer (ETFE) or an ethylene/trichlorofluoroethylene copolymer (ETCFE).

Each of such resins may further have a small amount of a comonomer component co-polymerized, as the case requires.

Such a comonomer component may be a monomer co-polymerizable with other monomers to constitute each resin (e.g. tetrafluoroethylene and ethylene in the case of ETFE), and for example, the following compounds may be mentioned.
A fluorinated ethylene such as CF₂=CFCl or CF₂=CH₂;
a fluorinated propylene such as CF₂=CFCF₃ or CF₂=CHCF₃;
a fluorinated alkylethylene having a C₂₋₁₀ fluoroalkyl group, such as CH₂=CHC₂F₅, CH₂=CHC₄F₉, CH₂=CFC₄F₉ or CH₂=CF(CF₂)₃H;
a perfluoro(alkyl vinyl ether) such as CF₂=CFO(CF₂CFXO)ₘR^{f} (wherein R^{f} is a C₁₋₆ perfluoroalkyl group, X is a fluorine atom or a trifluoromethyl group, and m is an integer of from 1 to 5);
a vinyl ether having a group which can be converted to a carboxylic acid group or a sulfonic acid group, such as CF₂=CFOCF₂CF₂CF₂COOCH₃ or CF₂=CFOCF₂CF(CF₃)OCF₂CF₂SO₂F.

As the tetrafluoroethylene resin, among the above, PFA, FEP, ETFE or ETCFE is preferred, and ETFE is particularly preferred from the viewpoint of the cost, mechanical strength, sputtering film-forming property, etc.

ETFE is a copolymer composed mainly of ethylene units and tetrafluoroethylene units. Here, "units" means repeating units constituting a polymer.

In whole units constituting ETFE, the total content of ethylene units and tetrafluoroethylene units is preferably at least 90 mol%, more preferably at least 95 mol%, and may be 100 mol%.

The molar ratio of ethylene units/tetrafluoroethylene units in ETFE is preferably from 40/60 to 70/30, more preferably from 40/60 to 60/40.

ETFE may have a small amount of comonomer component units, as the case requires. The comonomer component in such comonomer component units may be the same as mentioned above.

When ETFE has such comonomer component units, the content of the comonomer component units in whole units constituting ETFE is preferably from 0.3 to 10 mol%, more preferably from 0.3 to 5 mol%.

The chlorotrifluoroethylene resin may, for example, be one having tetrafluoroethylene in the above described tetrafluoroethylene resin substituted by chlorotrifluoroethylene. Specifically, a chlorotrifluoroethylene homopolymer (CTFE) or an ethylene/chlorotrifluoroethylene copolymer (ECTFE) may, for example, be mentioned.

The fluororesin contained in the substrate sheet may be of one type, or two or more types.

The substrate sheet may be one made solely of the fluororesin or may be one made of a resin mixture of the fluororesin and another thermoplastic resin. In consideration of the effects of the present invention, however, the substrate sheet is preferably composed mainly of the fluororesin. The proportion of the fluororesin in the substrate sheet is preferably at least 50 mass%, more preferably at least 70 mass%, based on the total mass of the substrate sheet.

Said another thermoplastic resin may, for example, be an acrylic resin, a polyester resin, a polyurethane resin, a nylon resin, a polyethylene resin, a polyimide resin, a polyamide resin, a polyvinyl chloride resin or a polycarbonate resin.

Further, it is also possible to use a resin having additives, fillers, etc. such as pigment, an ultraviolet absorber, carbon black, carbon fiber, silicon carbide, glass fiber, mica, etc. incorporated.

Of the substrate sheet, the surface composition (as measured by X-ray photoelectron spectroscopy) of the surface in contact with the adhesion layer is such that the atomic percentage of nitrogen is at least 0.2 atomic% (hereinafter referred to as at%) and at most 3.0 at%, and the atomic percentage of oxygen is at least 1.0 at% and at most 5.0 at%. When the atomic percentage of oxygen is at least 1.0 at%, the initial adhesion to the filler layer made of e.g. EVA is improved, and when the atomic percentage of nitrogen is at least 0.2 at%, it is possible to maintain the sufficient adhesion over a long period of time. On the other hand, if the atomic percentage of oxygen or the atomic percentage of nitrogen exceeds the upper limit within the above range, the treatment energy for surface treatment to attain each atomic percentage tends to increase, the treated layer tends to be thick, and the long-term stability of the adhesion tends to deteriorate.

The atomic percentage of nitrogen is preferably at least 0.2 at% and less than 3.0 at%, more preferably at least 0.2 at% and at most 2.5 at%.

The atomic percentage of oxygen is preferably at least 1.0 at% and less than 5.0 at%, more preferably at least 2.0 at% and at most 4.0 at%.

Here, "the surface composition" is atomic concentrations at the surface (within a range of from 2 to 5 nm in depth from the outermost surface) of the substrate sheet and is obtained by the following procedure for measurement.

### (Procedure for measurement of surface composition)

Using an X-ray photoelectron spectroscopic apparatus (e.g. µ-ESCA Quantum 2000, manufactured by ULVAC-PHI, Inc.), the surface composition is calculated from a survey spectrum at a detection angle of 45° by means of the accompanying analysis software.

The atomic percentage of nitrogen and the atomic percentage of oxygen in the above surface composition can be adjusted by applying prescribed surface treatment to the surface. Specifically, it is possible to obtain a substrate sheet having such a surface composition by applying surface treatment by glow discharge (hereinafter referred to as glow discharge treatment) to at least one surface of the substrate sheet containing a fluororesin (a non-treated substrate sheet), so that in its surface composition (as measured by X-ray photoelectron spectroscopy), the atomic percentage of nitrogen becomes at least 0.2 at% and at most 3.0 at%, and the atomic percentage of oxygen becomes at least 1.0 at% and at most 5.0 at%. In the case of discharge treatment other than glow discharge, such as corona discharge treatment or arc discharge treatment, the value of the atomic percentage of oxygen is likely to be large, and it is difficult to bring the surface composition to the prescribed ranges.

The glow discharge treatment can be carried out by using a known surface treating apparatus, and by adjusting the treating conditions (such as the atmosphere gas, temperature, pressure, treatment intensity, etc.) at that time, it is possible to adjust the atomic percentage of nitrogen and the atomic percentage of oxygen. For example, when glow discharge treatment is carried out in a prescribed atmosphere gas, the atmosphere gas is made to be plasma, and by the action of such plasma, prescribed functional groups (a nitrogen-containing functional group such as an amino group, and an oxygen-containing functional group such as a carboxy group, a carbonyl group or a hydroxy group) are introduced to the substrate sheet surface, whereby the atomic percentage of nitrogen and the atomic percentage of oxygen will increase. At that time, the types of functional groups to be introduced and the amounts to be introduced can be adjusted by the composition of the atmosphere gas. Further, as the treating intensity becomes high, the amount of functional groups to be introduced will increase, and the atomic percentage of nitrogen and the atomic percentage of oxygen become high.

The glow discharge treatment can be carried out, for example, by disposing the substrate sheet between opposite electrodes so that the surface to be treated by surface treatment is exposed in the atmosphere gas, and a high frequency voltage of from about 0.5 kHz to 100 kHz is applied between the opposite electrodes. If the voltage is less than 0.5 kHz, the plasma density is low, and it takes time for the treatment, and if it exceeds 100 kHz, glow discharge is likely to shift to arc discharge. If the glow discharge shifts to arc discharge, the long term-stability of adhesion may not sufficiently be obtainable.

The atmosphere gas is preferably one containing an inert gas or a nitrogen-containing gas. The inert gas and the nitrogen-containing gas may be used as mixed. It is particularly preferred to contain at least an inert gas among them, since safe and more stabilized glow discharge is thereby obtainable.

The inert gas (rare gas) may, for example, be helium gas, argon gas, neon gas, krypton gas, xenon gas or radon gas. Among them, helium gas or argon gas is preferred, and argon gas is particularly preferred.

The glow discharge treatment in an inert gas serves to remove a depleted material of the fluororesin (for example, an ETFE depleted material in the case of an ETFE sheet) present at the surface of the substrate sheet containing the fluororesin and to prevent breakage of the polymer main chain, thereby to activate the substrate sheet surface. Therefore, after forming plasma in the vicinity of the substrate sheet surface by carrying out the glow discharge treatment in an inert gas, by contacting air to the substrate sheet surface, it is possible to form nitrogen-containing functional groups and oxygen-containing functional groups. Such reactions will be referred to as a postnitriding reaction and a postoxidizing reaction, respectively. Further, treatments to carry out such reactions will be referred to as nitriding reaction treatment and oxidizing reaction treatment, after the surface treatment by glow discharge.

In a case where oxygen contained in the atmosphere gas for glow discharge treatment is large in amount, the postnitriding reaction is less likely to occur. Therefore, in order to make the atomic percentage of nitrogen in the surface composition to be at least 0.2 at%, the oxygen concentration in the atmosphere gas is preferably at most 1 mol%.

The nitrogen-containing gas may, for example, be nitrogen gas or ammonia gas.

When glow discharge treatment is carried out in a nitrogen-containing gas atmosphere, nitrogen plasma will be generated in the vicinity of the substrate sheet surface. By such plasma, nitrogen-containing functional groups will be introduced to the polymer at the substrate sheet surface, whereby the atomic percentage of nitrogen at the substrate sheet surface will be improved, and the long-term stability of adhesion will be improved. Further, if oxygen is present in the vicinity at that time, oxygen-containing functional groups will also be formed.

However, if oxygen contained in the atmosphere gas is large in amount, nitrogen-containing functional groups tend to be hardly formed. Therefore, in order to make the atomic percentage of nitrogen in the surface composition to be at least 0.2 at%, the oxygen concentration in the atmosphere gas is preferably at most 1 mol%.

The atmosphere gas may contain a gas other than the inert gas and nitrogen-containing gas. Such other gas may, for example, be a carbon oxide-containing gas or a polymerizable unsaturated compound gas. After carrying out glow discharge treatment in an atmosphere of a carbon oxide-containing gas, nitriding reaction treatment may be carried out, or after carrying out glow discharge treatment in an atmosphere of a polymerizable unsaturated compound gas, nitriding reaction treatment, or nitriding reaction treatment and oxidizing reaction treatment, may be carried out.

The carbon oxide gas may, for example, be carbon dioxide gas or carbon monooxide. Carbon dioxide gas is particularly preferred, since a surface reaction product firmly bonded to the fluororesin, particularly to ETFE, is thereby obtainable. When glow discharge treatment is carried out in a carbon dioxide gas atmosphere, oxygen-containing functional groups will be introduced to the polymer at the surface of the substrate sheet, whereby the atomic percentage of oxygen at the substrate sheet surface will be improved, and the adhesion will be improved.

In a case where a carbon oxide gas contained in the atmosphere gas is large in amount, it is likely that the amount of nitrogen-containing functional groups to be introduced tends to be inadequate, and the long-term stability of adhesion may not sufficiently be obtainable. Therefore, the carbon oxide concentration in the atmosphere gas is preferably at most 10 mol%.

The polymerizable unsaturated compound gas may, for example, be a compound gas having a double bond, such as ethylene gas or propylene gas, and ethylene gas is preferred.

When glow discharge treatment is carried out in a polymerizable unsaturated compound gas atmosphere, functional groups will be effectively introduced, whereby the adhesion will be improved.

If the amount of the polymerizable unsaturated compound gas is too much to the inert gas or the nitrogen-containing gas, the initial discharge voltage tends to be high, and the discharge treatment tends to be hardly carried out. Therefore, the concentration of the polymerizable unsaturated compound in the atmosphere gas is preferably at most 10 mol%.

Among the above described, the atmosphere gas is preferably an inert gas, a nitrogen gas, or a mixed gas comprising an inert gas, a carbon oxide-containing gas and a polymerizable unsaturated compound gas, and such a mixed gas is particularly preferred.

The ratio (molar ratio) of the inert gas/carbon oxide-containing gas in such a mixed gas is preferably from 100/1 to 100/15. Further, the ratio (molar ratio) of the inert gas/polymerizable unsaturated compound gas is preferably from 100/3 to 100/10.

The pressure at the time of glow discharge treatment is not particularly limited so long as it is a pressure capable of maintaining the atmosphere gas to be in a gaseous state, and the treatment may be carried out under reduced pressure or under a pressure in the vicinity of the atmospheric pressure. It is preferred to carry out the treatment under a pressure in the vicinity of the atmospheric pressure, whereby it is not necessary to use an expensive apparatus. Further, in a case where the treatment is carried out under a pressure in the vicinity of the atmospheric pressure, it is not required to make the treatment space to be in a closed system, and the treatment may be carried out in an open system or a low level of air-sealing system. In a case where the treatment is to be carried out in an open system or a low level of air-sealing system, air will flow into the atmosphere, and therefore, even if no nitrogen gas or oxygen gas is contained in the atmosphere gas to be supplied, sufficient nitrogen-containing functional groups and oxygen-containing functional groups will be introduced to the substrate sheet surface.

The pressure in the vicinity of the atmospheric pressure is usually within a range of from 6.7×10⁴ to 1.1×10⁵ Pa (from 500 to 800 Torr), preferably within a range of from 9.3×10⁴ to 1.0×10⁵ Pa (from 700 to 780 Torr).

The temperature at the time of the glow discharge treatment is not particularly limited. It is usually within a range of from 10 to 80°C, preferably within a range of from 25 to 60°C.

The treating intensity (electric power × treating time/treating area, unit: W·min/m²) in the glow discharge treatment is preferably from 100 to 1,500 W·min/m², more preferably from 220 to 800 W·min/m². As the treating intensity is high, the atomic percentage of nitrogen or the atomic percentage of oxygen can be made high, and the initial adhesion is improved. However, if the treating intensity is too high, the atomic percentage of nitrogen or the atomic percentage of oxygen is likely to be too high, and the treated layer tends to be thick and is likely to be detached from the substrate sheet surface, and the long-term stability of adhesion is likely to be low.

A substrate sheet to be used in the present invention is obtainable by applying surface treatment by glow discharge to at least one surface of a non-treated substrate sheet so that in the surface composition, the atomic percentage of nitrogen and the atomic percentage of oxygen will be in the prescribed ranges, as described above.

The shape and size of the substrate sheet are not particularly limited and may be suitably determined depending upon the particular purpose. For example, in a case where the laminate is used as a protecting sheet for a solar cell module, they may be suitably determined depending upon the shape and size of the solar cell module.

The thickness of the substrate sheet is preferably at least 10 µm, more preferably at least 20 µm, from the viewpoint of the strength. The upper limit of the thickness is not particularly limited and may suitably be determined depending upon the particular purpose. For example, in a case where the laminate is used as a protecting sheet to be disposed on the side exposed to sunlight, of the cell of the solar cell module, the thinner the better with a view to improving the power generation efficiency due to a high light transmittance, and specifically, at most 300 µm is preferred, and at most 100 µm is more preferred.

### <Adhesion layer>

The adhesion layer contains an acrylic resin.

The acrylic resin may be any one so long as it is capable of forming a film, a known acrylic resin, e.g. an acrylic resin commonly used in the field of e.g. coating materials, may be used. It may, for example, be a poly(meth)acrylic acid or one having functional groups introduced into the molecular chain of a poly(meth)acrylic acid. Such functional groups may, for example, be a hydrocarbon group having some or all of hydrogen atoms substituted by other atoms or groups, a group having some of carbon atoms of such a hydrocarbon group substituted by heteroatoms such as nitrogen atoms or oxygen atoms, or a polysiloxane structure.

The hydrocarbon group may be an aromatic hydrocarbon group or an aliphatic hydrocarbon group having no aromaticity. The aromatic hydrocarbon may, for example, be a phenyl group, a benzyl group or a naphthyl group. The aliphatic hydrocarbon group may, for example, be a saturated hydrocarbon group such as an alkyl group or a cycloalkyl group, or an unsaturated hydrocarbon group such as an alkenyl group or a cycloalkenyl group.

The above group having some of carbon atoms in the hydrocarbon group substituted by heteroatoms, is not particularly limited, but preferred may, for example, be a group containing a heteroring, such as benzotriazole, benzophenone, triazine, a cyclic imide, morpholine, tetrahydrofuran or caprolactone.

The above polysiloxane structure may, for example, be a group which is formed by reacting (hydrolyzing or condensing) an alkoxysilane to an alkoxysilyl group in water.

Such functional groups may be bonded to terminals of the main chain or to a side chain, in the molecular chain of the acrylic resin. For example, from the viewpoint to introduction efficiency, it is preferred that they are bonded to a side chain.

The type of functional groups contained in the acrylic resin may be one type, or two or more types.

The acrylic resin is particularly preferably one which has, in its molecular chain, at least one type of group selected from the group consisting of an ultraviolet-absorbing group, an ultraviolet-stabilizing group, and a group to constitute a polysiloxane structure. It is thereby possible to further improve the weather resistance and long-term stability of adhesion, of the obtainable laminate.

The ultraviolet-absorbing group may be any group so long as it has an ultraviolet-absorbing ability, and it may be the same one as commonly used as an ultraviolet-absorbing group in an ultraviolet absorber. Particularly, an ultraviolet-absorbing group of benzotriazole type, benzophenone type or triazine type, is preferred.

The ultraviolet-stabilizing group may be any group so long as it is capable of capturing or deactivating radicals, active oxygen, etc. generated by ultraviolet light and may be the same one as commonly used as an ultraviolet-stabilizing group in an ultraviolet-stabilizer. Particularly, an ultraviolet-stabilizing group of a hindered amine type, such as a piperidine group, is preferred.

The polysiloxane structure may be the same one as mentioned above.

As the acrylic resin, one synthesized by a known synthetic method such as radical polymerization may be used, or a commercial product may be used. For example, as an acrylic resin having an ultraviolet-absorbing group and an ultraviolet-stabilizing group, HALSHYBRID UV-G manufactured by NIPPON SHOKUBAI CO., LTD. may be mentioned. As an acrylic resin having a polysiloxane structure, DYNACERA manufactured by JSR Corporation may, for example, be mentioned.

The adhesion layer preferably further contains a curing agent in order to improve the hydrolysis resistance. Such a curing agent may be contained as a reaction product with the above acrylic resin or may be contained in a non-reacted state.

The curing agent may suitably be selected for use among known curing agents, depending upon the acrylic resin to be used. As the curing agent, it is particularly preferred to contain at least one member selected from the group consisting of a polyisocyanate compound, an epoxy resin, an oxazoline group-containing resin, a tin compound, an aluminum compound and a zirconium compound, from the viewpoint of the weather resistance.

The amount of the curing agent to be incorporated may suitably be set depending upon the curing agent to be used. Although not particularly limited, it is usually within a range of from 0.1 to 20 parts by mass, preferably from 1 to 10 parts by mass, per 100 parts by mass of the acrylic resin.

Further, a silane coupling agent to improve the adhesion, a dye or pigment as a coloring agent, an ultraviolet absorber, etc. may be mixed.

The adhesion layer is preferably a coating film formed by a wet system coating method, whereby it is excellent in bending, etc.

Such an adhesion layer may be formed specifically by coating the surface having the above surface composition, of the substrate sheet, with a coating fluid containing the acrylic resin.

As the coating fluid, a resin solution having the acrylic resin dissolved in a solvent, or a composition solution having the above curing agent incorporated to such a resin solution, may be used.

The concentration of the acrylic resin in the coating fluid may suitably be set depending upon the thickness of the adhesion layer to be formed. It is usually from 0.5 to 50 mass%, preferably from 1 to 20 mass%.

The solvent may be any solvent so long as it is capable of dissolving components to be incorporated, and water may be used, or an organic solvent may be used.

As the coating method for the coating fluid, a common wet system coating method may be used. For example, a spin coating method, a gravure coating method, a roll coating method, a bar coating method, a reverse coating method, a die coating method or a spraying method may be mentioned, and any method may be used.

The amount of the coating fluid to be applied may suitably be set depending upon the film thickness of the adhesion layer to be formed.

A coating film can be formed by drying the coating film formed by the coating. The drying may be carried out by air drying at normal temperature, but is preferably carried out by heat-drying. The temperature for the heat-drying is preferably from about 40 to 150°C from the viewpoint of the dimensional stability.

The film thickness of the adhesion layer is preferably at least 100 nm, more preferably at least 200 nm, with a view to securing the moisture-proofing property and the adhesion to the substrate sheet. Further, it is preferably at most 5 µm, more preferably at most 1 µm, with a view to maintaining the light transmittance, maintaining the flexibility as the entire laminate or securing the adhesion to the substrate sheet.

### <Moisture-proofing layer>

The moisture-proofing layer contains, as its main component, at least one inorganic compound selected from the group consisting of inorganic oxides, inorganic nitrides and inorganic oxynitrides.

Here, "as its main component" means that the proportion of the inorganic compound in the moisture-proofing layer is at least 95 mol%. The proportion of the inorganic compound in the moisture-proofing layer is preferably 100 mol%. That is, the moisture-proofing layer is preferably one made of the above inorganic compound, or one containing the inorganic compound.

The above inorganic oxides may, for example, be silicon oxide, a metal oxide, etc. The metal in the metal oxide may, for example, be aluminum, titanium, zinc, magnesium or the like. As such an oxide, silicon oxide (SiOₓ, 0<x≦2) or aluminum oxide (AlOₓ, 0<x≦1.5) is particularly preferred.

The above inorganic nitrides may, for example, be silicon nitride (SiNₓ, 0<x≦1.3), aluminum nitride (AlNₓ, 0<x≦1), etc.

The above inorganic oxynitrides may, for example, be silicon oxynitride (SiOₓN_{y}, 0<x<1, and 0<y<1), etc.

The inorganic compound is preferably a Si compound or an Al compound, since it is excellent in transparency, steam-barrier property, etc. As the Si compound, at least one member selected from the group consisting of SiOₓ (O<x≦2), SiNₓ (0<x≦1.3) and SiOₓNy (0<x<1, and 0<y<1) is preferred, and as the Al compound, AlOₓ (0<x≦1.5) is preferred.

The moisture-proofing layer may be formed by a dry system method or by a wet system method, but a dry system method is preferred. A film (vapor-deposited film) to be formed by a dry system method is uniform in the film thickness as compared with the film to be formed by a wet system method, and also the adhesion to the adhesion layer is high.

The dry system method may, for example, be a physical vapor-deposition method (PVD method) or a chemical vapor deposition method (CVD method).

The PVD method may, for example, be a vacuum vapor deposition method, a sputtering method or an ion plating method, and any method may be employed. Among them, a sputtering method is particularly preferred, since it is excellent in the productivity and is industrially widely used and whereby a very dense film having high adhesion to the above adhesion layer can be obtained in a uniform thickness. As the sputtering method, any of a DC sputtering method, a high frequency sputtering method and an AC sputtering method may be employed. A DC sputtering method or an AC sputtering method is preferred in view of excellent productivity such that a film can be efficiently formed at a high film-forming speed on a substrate having a large area.

The CVD method may, for example, be a plasma CVD method, a catalytic CVD method or a heat CVD method, and any method may be employed. Among them, a plasma CVD method is preferred, since a uniform and dense film can thereby be formed at a low temperature.

Specific conditions for forming the moisture-proofing layer may suitably be set depending upon the method and material to be used.

For example, an AlOₓ film may be obtained by film forming by a sputtering method in an oxygen-containing atmosphere using an aluminum target. At that time, by a method of applying an intermittent negative DC voltage to the target, it is possible to increase the applied electric power while effectively preventing arching during the film forming and further maintain a high film forming speed for a long hour. Specific conditions for sputtering at that time may suitably be selected, since they vary depending upon various conditions such as the type of the apparatus, the composition of the target, etc. Usually, it is preferred to carry out the sputtering under a sputtering gas pressure of from 0.1 to 1.3 Pa (1×10⁻³ to 10×10⁻³ Torr) at a power density of from 0.5 to 5 W/cm², by introducing argon and oxygen into a container at a flow ratio of from 0:100 to 90:10 after vacuuming to a level of from 1.3×10⁻³ to 1.3×10⁻² Pa (1×10⁻⁵ to 1×10⁻⁴ Torr).

The moisture-proofing layer may be one composed of a single layer or one composed of a plurality of layers different in material (e.g. in the inorganic compound as the main component).

The thickness of the moisture-proofing layer (the total thickness in the case of one composed of a plurality of layers) is preferably at least 10 nm from the viewpoint of the moisture-proofing property. If it is too thick, the moisture-proofing property is likely to deteriorate due to formation of cracks, and therefore, the thickness is preferably at most 1,000 nm, more preferably at most 100 nm.

Having the above construction, the laminate of the present invention is excellent in weather resistance and moisture-proofing property and is also excellent in the interlayer adhesion and its long-term stability. That is, since the adhesion layer contains an acrylic resin, the adhesion between the adhesion layer and the moisture-proofing layer is high, and the substrate sheet containing a fluororesin is excellent in weather resistance, heat resistance and chemical resistance, and since the surface in contact with the adhesion layer, of the substrate sheet, has the prescribed surface composition, the adhesion between the substrate sheet and the adhesion layer is high, and its long-term stability is also excellent. Therefore, the adhesion as the entire laminate and its long-term stability are high.

Therefore, the laminate of the present invention is useful as a protecting sheet for a solar cell module.

For example, since the adhesion as the entire laminate and its long-term stability are high, a solar cell module having the laminate disposed so that the surface on the moisture proofing layer side becomes the side of a filler layer of e.g. EVA, is less susceptible to deterioration of the adhesion strength between the substrate sheet and the filler layer.

Further, the substrate sheet containing the fluororesin is excellent not only in weather resistance, heat resistance and chemical resistance but also in anti-fouling property. Therefore, when the laminate is disposed so that the outermost layer of the solar cell module becomes the substrate sheet, a dust or dirt is less likely to be deposited on the solar cell module surface, whereby it is possible to prevent deterioration of the performance due to fouling over a long period of time.

Further, in the laminate, the transparency of each of the substrate sheet, the adhesion layer and the moisture-proofing layer is high, and the transparency of the entire laminate is high. Therefore, such a laminate is useful as a protecting sheet to protect the side of the cell exposed to sunlight, in the solar cell module.

In a case where the laminate of the present invention is used as a protecting sheet to protect the side of the cell exposed to sunlight in the solar cell module, the visible light transmittance of the laminate is preferably at least 80%, more preferably at least 90%. The upper limit is not particularly limited, since the higher the visible light transmittance, the better, but from the practical viewpoint, it is about 98%.

### EXAMPLES

Now, specific examples of the above embodiments will be described as Examples. It should be understood, however, that the present invention is by no means limited to the following Examples.

The measurement methods and evaluation methods used in the following respective Examples are as follows.

### [Measurement of surface composition by ESCA]

Using an X-ray photoelectron spectroscopic apparatus (µ-ESCA Quantum 2000, manufactured by ULVAC-PHI, Inc.), the surface composition [atomic concentration (at%)] was calculated by means of the accompanying analysis software (multipack) from a survey spectrum at a detection angle of 45°. Using monochromatic AlKα-ray (26.00 eV) as excitation X-ray, the measurement was made with an output of 24.9 W.

### [Measurement of visible light transmittance]

The spectral transmission spectrum was measured by using a spectroscope (tradename "UV-3100PC", manufactured by Shimadzu Corporation), and from the measured value, the visible light transmittance (%) was calculated, based on JIS R3106-1998.

### [Thickness of each layer]

The thickness was measured by using a spectral ellipsometry apparatus (tradename "M-2000DI", manufactured by J.A.WOOLLAM JAPAN) and calculated by carrying out optical fitting by means of WVASE32 (manufactured by J.A.WOOLAM).

### [Evaluation of adhesion (measurement of adhesion strength)]

A laminate obtained in each of Examples and Comparative Examples was cut into a size of 10 cm × 10 cm, and the laminate thus cut and an EVA film (W25CL manufactured by Bridgestone Corporation) cut into the same size were disposed so that the order would be ETFE film/acrylic resin layer/moisture-proofing layer/EVA film (only in Comparative Example 3, the order would be ETFE film/moisture-proofing layer/EVA film) and subjected to thermal compression bonding by a press machine (manufactured by Asahi Glass Company, Limited) under such conditions that the pressure was 10 kgf/cm, the area was 120 cm², the temperature was 150°C and the time was 10 minutes, to obtain a test piece.

Then, each test piece was cut into a size of 1 cm × 10 cm, and by using a Tensilon universal tester RTC-1310A manufactured by ORIENTEC CO., LTD., the adhesion strength (peel bond strength, unit: N/cm) was measured by a 180° peeling test at a tensile speed of 50 mm/min in accordance with JIS K6854-2.

The measurement of the adhesion strength was carried out before the weather resistance test (initial) and after the following weather resistance test I or II.

Weather resistance test I: carried out by using a sunshine carbon arc type weather resistance tester (Sunshine weather meter S300 manufactured by Suga Test Instruments Co., Ltd.) in accordance with JIS B7753.

Weather resistance test II: A weather resistance test in an environment of 85°C with a relative humidity of 85%, was carried out by using Platinous PL-1 KPH constant temperature high humidity machine manufactured by ESPEC CORP.

### [Example 1]

An ETFE film having a thickness of 50 µm (tradename: AFLEX, manufactured by Asahi Glass Company, Limited) was subjected to surface treatment by glow discharge with a treating density of 354 W·min/m² in a nitrogen gas atmosphere having a purity of 99.99 vol% at a frequency of 40 Hz for a voltage rising time of 1.5 µsec, for a voltage falling time of 1.5 µsec, for a pulse duration of 20 µsec. at 30°C under the atmospheric pressure. The results of measurement of the surface composition after the surface treatment are shown in Table 1.

Then, 2.8 parts by mass of a curing agent (tradename: Desmodur N3200, manufactured by Sumika Bayer Urethane Co., Ltd.) was added to 100 parts by mass of acrylic resin A1 (tradename: HALSHYBRID UV-G13, manufactured by NIPPON SHOKUBAI CO., LTD., acrylic resin having ultraviolet absorbing groups and ultraviolet-stabilizing groups (hindered amine photostabilizing groups (HALS)) chemically incorporated to the resin skeleton), followed by diluting with toluene to prepare a coating fluid having a resin concentration of 10 mass%. Such a coating fluid was applied to the surface-treated side of the above ETFE film and dried for 30 minutes in an oven at 60°C to form a coating film. The dried mass of the coating film was 1 g/m², and the film thickness was 1 µm.

The ETFE film with the coating film was set in a sputtering apparatus (manufactured by Tokki Co., Ltd.) and vacuumed to a level of 6.7×10⁻⁴ Pa (5×10⁻⁶ Torr), and then using aluminum as a target and introducing 50 sccm of Ar gas and 3 sccm of O₂ gas into the chamber, discharge was carried out at a DC voltage of 320 V. By controlling the deposition time by opening or closing the shutter, an aluminum oxide thin film was deposited in a thickness of 20 nm thereby to obtain a laminate composed of ETFE film/acrylic resin A1/aluminum oxide (moisture-proofing layer). With respect to such a laminate, the visible light transmittance (%) and the adhesion strength (initial stage and after the weather resistance test) were measured. The results are shown in Table 1.

### [Example 2]

An ETFE film having a thickness of 50 µm (tradename: AFLEX, manufactured by Asahi Glass Company, Limited) was subjected to surface treatment by glow discharge with a treating density of 300 W·min/m² in a mixed gas atmosphere composed of argon gas/ethylene gas/carbon dioxide gas = 100/7/2 (molar ratio) at a frequency of 40 Hz for a voltage rising time of 1.5 µsec. for a voltage falling time of 1.5 µsec, for pulse duration of 20 µsec, at 30°C under the atmospheric pressure. The results of measurement of the surface composition after the surface treatment are shown in Table 1.

Then, 2.8 parts by mass of a curing agent (tradename: Desmodur N3200, manufactured by Sumika Bayer Urethane Co., Ltd.) was added to 100 parts by mass of the above mentioned acrylic resin A1 (tradename: HALSHYBRID UV-G13, manufactured by NIPPON SHOKUBAI CO., LTD.), followed by diluting with toluene to prepare a coating fluid having a resin concentration of 10 mass%. Such a coating fluid was applied by a bar coater to the surface-treated side of the above ETFE film and dried for 30 minutes in an oven at 60°C to form a coating film. The dried mass of the coating film was 1 g/m², and the film thickness was 1 µm.

The ETFE film with the coating film was set in a sputtering apparatus (manufactured by Tokki Co., Ltd.) and vacuumed to a level of 6.7×10⁻⁴ Pa (5×10⁻⁶ Torr) and then, using aluminum as a target and introducing 50 sccm of Ar gas and 3 sccm of O₂ gas into the chamber, discharge was carried out at a DC voltage of 320 V. By controlling the deposition time by opening or closing the shutter, an aluminum oxide thin film was deposited in a thickness of 20 nm thereby to obtain a laminate composed of ETFE film/acrylic resin A1/aluminum oxide (moisture-proofing layer). With respect to such a laminate, the visible light transmittance (%) and the adhesion strength (initial stage and after the weather resistance test) were measured. The results are shown in Table 1.

### [Comparative Example 1]

An ETFE film having a thickness of 50 µm (tradename: AFLEX, manufactured by Asahi Glass Company, Limited) was subjected to surface treatment by corona discharge in air (25°C, atmospheric pressure) by using a surface treating apparatus (manufactured by KASUGA ELECTRIC WORKS LTD).

Then, 2.8 parts by mass of a curing agent (tradename: Desmodur N3200, manufactured by Sumika Bayer Urethane Co., Ltd.) was added to 100 parts by mass of the above acrylic resin A1 (tradename: HALSHYBRID UV-G13, manufactured by NIPPON SHOKUBAI CO., LTD.), followed by diluting with toluene to prepare a coating fluid having a resin concentration of 10 mass%. Such a coating fluid was applied by a bar coater to the surface-treated side of the above ETFE film and dried for 30 minutes in an oven at 60°C to form a coating film. The dried mass of the coating film was 1 g/m², and the film thickness was 1 µm.

The ETFE film with the coating film was set in a sputtering apparatus (manufactured by Tokki Co., Ltd.) and vacuumed to a level of 6.7×10⁻⁴ Pa (5×10⁻⁶ Torr), and then, using aluminum as a target and introducing 50 sccm of Ar gas and 3 sccm of O₂ gas into the chamber, discharge was carried out at a DC voltage of 320 V. By controlling the deposition time by opening or closing the shutter, an aluminum oxide thin film was deposited in a thickness of 20 nm thereby to obtain a laminate composed of ETFE film/acrylic resin A1/aluminum oxide (moisture-proofing layer). With respect to such a laminate, the visible light transmittance (%) and the adhesion strength (initial stage and after the weather resistance test) were measured. The results are shown in Table 1.

### [Example 3]

An ETFE film having a thickness of 50 µm (tradename: AFLEX, manufactured by Asahi Glass Company, Limited) was subjected to surface treatment by glow discharge with a treating density of 354 W·min/m² in a nitrogen gas atmosphere having a purity of 99.99 vol% at a frequency of 40 Hz for a voltage rising time of 1.5 µsec, for a voltage falling time of 1.5 µses, for a pulse duration of 20 µsec. at 30°C under the atmospheric pressure. The results of measurement of the surface composition after the surface treatment are shown in Table 1.

Then, 6 parts by mass of a curing agent (tradename: GLASCA H553, manufactured by JSR Corporation, zirconia-modified compound) was mixed to 100 parts by mass of an acrylic resin A2-containing liquid (tradename: DYNACERA T8306, manufactured by JSR Corporation, a solution of a hydrolyzed condensate obtainable by reacting (hydrolyzing or cocondensing) an alkoxysilyl group-containing acrylic resin and an alkoxysilane) to prepare a coating fluid. Such a coating fluid was applied by a bar coater to the surface-treated side of the above ETFE film and dried for 30 minutes in an oven at 60°C to form a coating film. The dried mass of the coating film was 1 g/m², and the film thickness was 1 µm.

The ETFE film with the coating film was set in a sputtering apparatus (manufactured by Tokki Co., Ltd.) and vacuumed to a level of 6.7×10⁻⁴ Pa (5×10⁻⁶ Torr), and then, using aluminum as a target and introducing 50 sccm of Ar gas and 3 sccm of O₂ gas into the chamber, discharge was carried out at a DC voltage of 320 V. By controlling the deposition time by opening or closing the shutter, an aluminum oxide thin film was deposited in a thickness of 20 nm thereby to obtain a laminate composed of ETFE film/acrylic resin A2/aluminum oxide (moisture-proofing layer). With respect to such a laminate, the visible light transmittance (%) and the adhesion strength (initial stage and after the weather resistance test) were measured. The results are shown in Table 1.

### [Example 4]

An ETFE film having a thickness of 50 µm (tradename: AFLEX, manufactured by Asahi Glass Company, Limited) was subjected to surface treatment by glow discharge with a treating density of 300 W·min/m² in a mixed gas atmosphere composed of argon gas/ethylene gas/carbon dioxide gas = 100/7/2 (molar ratio) at a frequency of 40 Hz for a voltage rising time of 1.5 µsec. for a voltage falling time of 1.5 µsec. for a pulse duration of 20 µsec. at 30°C under the atmospheric pressure. The results of measurement of the surface composition after the surface treatment are shown in Table 1.

Then, 6 parts by mass of a curing agent (tradename: GLASCA H553, manufactured by JSR Corporation) was mixed to 100 parts by mass of the above acrylic resin A2-containing liquid (tradename: DYNACERA T8306, manufactured by JSR Corporation) to prepare a coating fluid. Such a coating fluid was applied by a bar coater to the surface-treated side of the above ETFE film and dried for 30 minutes in an oven at 60°C to form a coating film. The dried mass of the coating film was 1 g/m², and the film thickness was 1 µm.

The ETFE film with the coating film was set in a sputtering apparatus (manufactured by Tokki Co., Ltd.) and vacuumed to a level of 6.7×10⁻⁴ Pa (5×10⁻⁶ Torr), and then, using aluminum as a target and introducing 50 sccm of Ar gas and 3 sccm of O₂ gas into the chamber, discharge was carried out at a DC voltage of 320 V. By controlling the deposition time by opening or closing the shutter, an aluminum oxide thin film was deposited in a thickness of 20 nm thereby to obtain a laminate composed of ETFE film/acrylic resin A2/aluminum oxide (moisture-proofing layer). With respect to such a laminate, the visible light transmittance (%) and the adhesion strength (initial stage and after the weather resistance test) were measured. The results are shown in Table 1.

### [Comparative Example 2]

An ETFE film having a thickness of 50 µm (tradename: AFLEX, manufactured by Asahi Glass Company, Limited) was subjected to surface treatment by corona discharge in air (25°C, atmospheric pressure) by using a surface treating apparatus (manufactured by KASUGA ELECTRIC WORKS LTD).

Then, 6 parts by mass of a curing agent (tradename: GLASCA H553, manufactured by JSR Corporation) was mixed to 100 parts by mass of the above acrylic resin A2-containing liquid (tradename: DYNACERA T8306, manufactured by JSR Corporation) to prepare a coating fluid. Such a coating fluid was applied by a bar coater to the surface-treated side of the above ETFE film, and dried for 30 minutes in an oven at 60°C to form a coating film. The dried mass of the coating film was 1 g/m², and the film thickness was 1 µm.

The ETFE film with the coating film was set in a sputtering apparatus (manufactured by Tokki Co., Ltd.) and vacuumed to a level of 6.7×10⁻⁴ Pa (5×10⁻⁶ Torr), and then, using aluminum as a target and introducing 50 sccm of Ar gas and 3 sccm of O₂ gas into the chamber, discharge was carried out at a DC voltage of 320 V. By controlling the deposition time by opening or closing the shutter, an aluminum oxide thin film was deposited in a thickness of 20 nm thereby to obtain a laminate composed of ETFE film/acrylic resin A2/aluminum oxide (moisture-proofing layer). With respect to such a laminate, the visible light transmittance (%) and the adhesion strength (initial stage and after the weather resistance test) were measured. The results are shown in Table 1.

### [Example 5]

An ETFE film having a thickness of 50 µm (tradename: AFLEX, manufactured by Asahi Glass Company, Limited) was subjected to surface treatment by glow discharge with a treating density of 300 W·min/m² in a mixed gas atmosphere composed of argon gas/ethylene gas/carbon dioxide gas = 100/7/2 (molar ratio) at a frequency of 40 Hz for a voltage rising time of 1.5 µsec, for a voltage falling time of 1.5 µsec. for a pulse duration of 20 µsec, at 30°C under the atmospheric pressure. The results of measurement of the surface composition after the surface treatment are shown in Table 1.

Then, 2.8 parts by mass of a curing agent (tradename: Desmodur N3200, manufactured by Sumika Bayer Urethane Co., Ltd.) was added to 100 parts by mass of the above acrylic resin A1 (tradename: HALSHYBRID UV-G13, manufactured by NIPPON SHOKUBAI CO., LTD.), followed by diluting with toluene to prepare a coating fluid having a resin concentration of 10 mass%. Such a coating fluid was applied by a bar coater to the surface-treated side of the above ETFE film and dried for 30 minutes in an oven at 60°C to form a coating film. The dried mass of the coating film was 1 g/m², and the film thickness was 1 µm.

The ETFE film with the coating film was mounted on a delivery roll in a plasma chemical vapor deposition apparatus, and on the surface on its coating film side, a vapor-deposited film (CVD film) of silicon oxynitride having a thickness of 100 nm was formed under the following conditions, thereby to obtain a laminate composed of ETFE film/acrylic resin A1/silicon oxynitride (moisture-proofing layer). With respect to such a laminate, the visible light transmittance (%) and the adhesion strength (initial stage and after the weather resistance test) were measured. The results are shown in Table 1.

### (Vapor deposition conditions)

Reaction gas mixing ratio: monosilane/nitrogen gas = 100 sccm/1,000 sccm
Attained vacuum degree: 5×10⁻⁴ Pa
Deposition pressure: 1.0 Pa
Power applied to electrodes: 2 kW
Film transportation velocity: 1 m/min

### [Example 6]

In the same procedure as in Example 5, an ETFE film with a coating film (ETFE film/acrylic resin A1) was prepared. The ETFE film with the coating film was placed in Electron Beam vapor deposition apparatus (manufactured by SHOWA SHINKU CO., LTD.), and on the surface on its coating film side, a vapor-deposited film of aluminum oxide having a thickness of 100 nm was formed under the following conditions thereby to obtain a laminate composed of ETFE film/acrylic resin A1/aluminum oxide (moisture-proofing layer). With respect to such a laminate, the visible light transmittance (%) and the adhesion strength (initial stage and after the weather resistance test) were measured. The results are shown in Table 1.

### (Vapor deposition conditions)

Reaction gas mixing ratio: oxygen gas = 20 sccm
Attained vacuum degree: 5×10⁻⁴ Pa
Deposition pressure: 0.04 Pa
Applied voltage: 10 kV
Current density: 80 mA
Vapor deposition source: Al (4N: purity of at least 99.99%)
Deposition time: 3 seconds

### [Comparative Example 3]

An ETFE film having a thickness of 50 µm (tradename: AFLEX, manufactured by Asahi Glass Company, Limited) was set in a sputtering apparatus (manufactured by Tokki Co., Ltd.) and vacuumed to a level of 6.7×10⁻⁴ Pa (5×10⁻⁶ Torr), and then, using aluminum as a target and introducing 50 sccm of Ar gas and 3 sccm of O₂ gas into the chamber, discharge was carried out at a DC voltage of 320 V. By controlling the deposition time by opening or closing the shutter, an aluminum oxide thin film was deposited in a thickness of 20 nm thereby to obtain a laminate composed of ETFE film/aluminum oxide (moisture-proofing layer). With respect to such a laminate, the visible light transmittance (%) and the adhesion strength (initial stage and after the weather resistance test) were measured. The results are shown in Table 1.

**TABLE 1**

| | ETFE film | | | | | Adhesion layer | Moisture-proofing layer | | Visible light transmittance (%) | Adhesion strength (N/cm) | | |
|---|---|---|---|---|---|---|---|---|---|---|---|---|
| | Surface treatment | Surface composition (at%) | | | | | Material | Thickness (nm) | | Initial stage | After weather resistance test | |
| | | N | O | C | F | | | | | | I | II |
| Ex. 1 | Glow discharge (N₂ gas) | 2.3 | 2.6 | 46.9 | 48.3 | A1 | Al₂O₃ (Sputtering) | 20 | 95 | 16 | 15 | 12 |
| Ex. 2 | Glow discharge (mixed gas) | 0.2 | 3.8 | 52.1 | 43.9 | A1 | Al₂O₃ (Sputtering) | 20 | 95 | 16 | 14 | 13 |
| Comp. Ex. 1 | Corona discharge | 0 | 2.3 | 49.5 | 48.2 | A1 | Al₂O₃ (Sputtering) | 20 | 95 | 12 | 6 | 3 |
| Ex. 3 | Glow discharge (N₂ gas) | 2.3 | 2.6 | 46.9 | 48.3 | A2 | Al₂O₃ Al₂O₃ (Sputtering) | 20 | 95 | 15 | 14 | 12 |
| Ex. 4 | Glow discharge (mixed gas) | 0.2 | 3.8 | 52.1 | 43.9 | A2 | Al₂O₃ (Sputtering) | 20 | 95 | 15 | 15 | 13 |
| Comp. Ex. 2 | Corona discharge | 0 | 2.3 | 49.5 | 48.2 | A2 | Al₂O₃ (Sputtering) | 20 | 95 | 14 | 13 | 3 |
| Ex. 5 | Glow discharge (mixed gas) | 0.2 | 3.8 | 52.1 | 43.9 | A1 | SiON (CVD) | 100 | 95 | 15 | 14 | 13 |
| Ex. 6 | Glow discharge (mixed gas) | 0.2 | 3.8 | 52.1 | 43.9 | A1 | Al₂O₃ (EB vapor deposition) | 100 | 95 | 15 | 14 | 13 |
| Comp. Ex. 3 | - | 0 | 0.1 | 46.3 | 53.6 | - | Al₂O₃ (Sputtering) | 100 | 95 | 0.1 | - | 0.1 |

As shown by the above results, the laminates in Examples 1 to 6 had high transparency equivalent to the laminate in Comparative Example 3 wherein no adhesion layer was formed, and the initial adhesion to the EVA film was high, and substantially the same adhesion was maintained after the weather resistance test.

On the other hand, with the laminates in Comparative Examples 1 and 2 wherein the atomic percentage of nitrogen in the ETFE film surface was 0, although the initial adhesion was good, the adhesion was substantially lowered after the weather resistance test. Further, with the laminate in Comparative Example 3 wherein the atomic percentage of nitrogen was 0, and the atomic percentage of oxygen was 0.1 at%, the adhesion was poor both at the initial stage and after the weather resistance test.

### INDUSTRIAL APPLICABILITY

The laminate of the present invention is excellent in weather resistance and moisture-proofing property and also excellent in interlayer adhesion and its long-term stability and is useful as a protecting sheet for a solar cell module to protect the side of the cell exposed to sunlight, or as a protecting sheet for a display.

The entire disclosure of Japanese Patent Application No. 2010-049508 filed on March 5, 2010 including specification, claims and summary is incorporated herein by reference in its entirety.

## Claims

1. A laminate which comprises a substrate sheet containing a fluororesin, an adhesion layer containing an acrylic resin, and a moisture-proofing layer containing, as its main component, at least one inorganic compound selected from the group consisting of inorganic oxides, inorganic nitrides and inorganic oxynitrides, laminated in this order, wherein the surface composition (as measured by X-ray photoelectron spectroscopy) of the surface in contact with the adhesion layer, of the substrate sheet, is such that the atomic percentage of nitrogen is at least 0.2 at% and at most 3.0 at%, and the atomic percentage of oxygen is at least 1.0 at% and at most 5.0 at%.

2. The laminate according to Claim 1, wherein the acrylic resin has, in its molecular chain, at least one type of group selected from the group consisting of an ultraviolet-absorbing group, an ultraviolet-stabilizing group, and a group to constitute a polysiloxane structure.

3. The laminate according to Claim 1 or 2, wherein the fluororesin is an ethylene/tetrafluoroethylene copolymer.

4. The laminate according to any one of Claims 1 to 3, wherein the moisture-proofing layer contains, as the inorganic compound, a Si compound or an Al compound.

5. The laminate according to any one of Claims 1 to 4, which has a visible light transmittance of at least 80%.

6. A protecting sheet for a solar cell module, which uses the laminate as defined in any one of Claims 1 to 5.

7. A process for producing the laminate as defined in any one of Claims 1 to 5, which comprises:
a step of applying surface treatment by glow discharge to at least one surface of the substrate sheet containing a fluororesin, so that in its surface composition (as measured by X-ray photoelectron spectroscopy), the atomic percentage of nitrogen becomes at least 0.2 at% and at most 3.0 at%, and the atomic percentage of oxygen becomes at least 1.0 at% and at most 5.0 at%,
a step of coating the surface having the above surface composition, of the substrate sheet, with a coating fluid containing the acrylic resin, to form the adhesion layer, and
a step of forming the moisture-proofing layer on the adhesion layer by a dry system method.

8. The process for producing the laminate according to Claim 7, wherein the atmosphere gas in the glow discharge contains at least one type of gas selected from the group consisting of an inert gas and a nitrogen-containing gas.

9. The process for producing the laminate according to Claim 7, wherein the atmosphere gas in the glow discharge is a mixed gas comprising an inert gas, a carbon oxide-containing gas and a polymerizable unsaturated compound gas.
